# EUROPEAN PATENT APPLICATION

(11) **EP 4 597 586 A1**
(43) Date of publication of application: **06.08.2025**
(21) Application number: 23871373.9
(22) Date of filing: 10.07.2023
(51) Int. Cl.: H01L 33/00, H01L 33/36

(54) **MICRO-LED CHARACTERISTICS EVALUATION WAFER AND MICRO-LED CHARACTERISTICS EVALUATION METHOD**

(30) Priority: 29.09.2022 JP 2022156788
(71) Applicant: Shin-Etsu Handotai Co., Ltd., Tokyo 100-0004 (JP)
(72) Inventor: ISHIZAKI, Junya, Annaka-shi, Gunma 379-0196 (JP); FURUYA, Shogo, Annaka-shi, Gunma 379-0196 (JP)
(74) Representative: Schicker, Silvia
(86) International application number: PCT/JP2023/025465
(87) International publication number: WO 2024/070129

(57) **Abstract**

A wafer for micro LED characteristic evaluation includes a GaAs substrate, a micro LED having a side of 100 µm or less on the GaAs substrate, a pad base adjacent to the micro LED, an upper electrode pad on the micro LED and the pad base, and a lower electrode pad on the GaAs substrate in the vicinity of the micro LED. The micro LED and the pad base are coupled through an insulator. Thus, the present invention provides a wafer for micro LED characteristic evaluation that enables evaluation of current-carrying properties by forming a micro LED-size device in an epitaxial wafer state as it is, and enables evaluation of transient properties without disconnection under environmental testing.

## Description

### TECHNICAL FIELD

The present invention relates to a wafer for micro LED characteristic evaluation and a micro LED characteristic evaluation method.

### BACKGROUND ART

Techniques to realize micro LED displays have been disclosed, in which LEDs are lifted off from a starting substrate and transferred to a substrate for mounting by using laser lift-off (LLO) and transferred to a drive substrate (Patent Document 1). However, all the techniques are directed to GaN-based LEDs, and there is no technical disclosure on micro LEDs using AlGaInP-based LEDs.

When micro LED devices are realized with AlGaInP-based LEDs, it is important to determine whether the quality of epitaxial wafers is suitable for micro LEDs. In particular, it is important to grasp transient (lifetime) properties of LEDs. In conventional discrete LEDs with a size of 150 µm square or more, an epitaxial wafer provided with electrodes on its top and bottom is cut into dies of 150 µm square or more. The die is mounted on an energizing jig such as TO-18CAN with conductive paste, and a metal wire is wire-bonded to the top of the die, resulting in a device that can carry current. Current is applied to the device to evaluate transient (life) properties.

In micro LEDs, however, the device size is 100 µm square or less. A bonding electrode (pad) required for wire bonding must be 90 µm or more in diameter for wedge bonding and 70 µm or more in diameter for ball bonding. Since micro LEDs have a typical size of 50 µm square or less and often have a size of 5 to 20 µm square, it is obvious that they cannot be evaluated with the same design as those for conventional discrete LEDs.

Although it is possible to mount a micro LED device on the drive substrate to conduct testing, micro LEDs transfer is necessary, and information on quality change associated with the transfer is contained. This is, therefore, not appropriate for evaluating the quality of the epitaxial layer itself. In addition, it takes too much time before evaluation because a device formation process and a mounting process are required, and evaluation cost is too high because the evaluation requires the use of a drive substrate for products.

Moreover, if the micro LEDs are mounted on the drive substrate and evaluated by applying current, the thermal design is significantly different from when they are mounted on TO-18CAN. When mounted, due to low thermal resistance, the micro LEDs have excellent heat dissipation and exhibit apparently better behavior than the original quality of the epitaxial layer. Although the thermal design is good as a product, it is not appropriate for controlling the quality of the epitaxial layer. Unless testing is performed with a thermal design equivalent to that when mounted on TO-18CAN, the testing is inappropriate as quality evaluation of the epitaxial layer.

Therefore, it is necessary to disclose a technique of a device and a device structure that can be mounted and tested on TO-18CAN. However, there is no technical disclosure of a device and a device structure for micro LEDs that can be mounted on TO-18CAN and tested for transient properties.

When the device size is small, a method that utilizes a technique of arranging wiring on the side face of the device can be considered (Patent Document 2). This technique is effective for a structure in which the upper layer is not very thick.

In the AlGaInP-based LED structure, which is premised on laser lift-off (LLO), however, a double hetero (DH) portion including an active layer is formed on a starting substrate, and a GaP layer serving as a base is formed sequentially. In this structure, the DH portion is positioned below, and the GaP layer is positioned above.

If the technique disclosed in Patent Document 2 is applied to this structure, significant deep etching is required to penetrate the GaP layer and electrically isolate the DH layer portion. The GaP layer is typically 4 µm or more, and the AlGaInP-based DH portion is typically 2 µm or more, so the etching depth is 6 µm or more.

When wiring is provided on a side surface of such a deep-etched device, electrical disconnection is likely to occur at the side surface portion. This is because the deep-etched side surface portion is uneven and difficult to be reliably covered with a metal.

Patent Document 3 discloses a technique for wiring in a deep etched portion. In this technique, an insulating film is formed on a deep-etched trench side surface, and a contact electrode is extended to a lower cladding layer to make a contact. This method requires complex steps of etching the trench, covering the side surface with the insulating film, etching the bottom, and filling the trench with an electrode metal. This method is for forming the electrode in the trench and is not simply applicable to micro LEDs.

Patent document 4 discloses a technique for transferring an epitaxial layer portion to another substrate and bringing a pad portion into contact with a device to apply current. In this technique, the device is buried in resin. In this case, the resin has a higher resistance (lower thermal conductivity) than the epitaxial starting substrate and is thermally isolated (separated). As a result, the junction temperature increases significantly compared with the ambient temperature. Transient testing for lifetime properties and the like is generally conducted by mounting a light emitting device on a material with a relatively lower thermal resistance than the thermal resistance of the base material of the light emitting device. It is not usual to conduct such testing by mounting the device on a material with poor heat dissipation that has a higher thermal resistance than the base material. When testing is performed using prior techniques, test conditions are very different from conventional conditions.

As described above, there is no prior technique that can evaluate the characteristics of an epitaxial wafer as it is, and there is no disclosure of design or technique that can evaluate whether an epitaxial wafer itself is a suitable epitaxial wafer when made into a micro LED size.

### CITATION LIST

### PATENT LITERATURE

Patent Document 1: JP 6838247 B2
Patent Document 2: JP 2012-195437 A
Patent Document 3: JP 2013-135234 A
Patent Document 4: JP 2003-282478 A

### SUMMARY OF INVENTION

### TECHNICAL PROBLEM

The present invention is made to solve the above problem. An object of the present invention is to provide a wafer for micro LED characteristic evaluation and a micro LED characteristic evaluation method that enable evaluation of current-carrying properties by forming a micro LED-size device in an epitaxial wafer state as it is without processing an epitaxial wafer having AlGaInP-based micro LEDs optimum for the LLO process into a wafer structure for LLO, and enable steady evaluation of transient properties with a device structure free from disconnection under environmental testing.

### SOLUTION TO PROBLEM

In order to achieve the above object, the present invention provides a wafer for micro LED characteristic evaluation, the wafer comprising:
a GaAs substrate;
a micro LED having a side of 100 µm or less on the GaAs substrate;
a pad base adjacent to the micro LED;
an upper electrode pad on the micro LED and the pad base; and
a lower electrode pad on the GaAs substrate in a vicinity of the micro LED,
wherein the micro LED and the pad base are coupled through an insulator.

In such a wafer for micro LED characteristic evaluation, the current-carrying properties of a micro LED-size device can be evaluated in an epitaxial wafer state as it is, and transient properties can be steadily evaluated without disconnection under environmental testing.

In this case, the upper electrode pad can have an area larger than an area of a circle with a diameter of 60 µm.

This configuration ensures reliable wire bonding.

In this case, the upper electrode pad can comprise a metal, and the metal may be any of Al, Cu, Ag, and Au.

With this configuration, the current-carrying properties of a micro LED-size device can be more reliably evaluated in an epitaxial wafer state as it is, and transient properties can be more steadily evaluated without disconnection under environmental testing.

In this case, the upper electrode pad can comprise a transparent conductive film, and the transparent conductive film can be any of ITO, InOₓ, NiO, and CuO.

With this configuration, the current-carrying properties of a micro LED-size device can be evaluated in an epitaxial wafer state as it is, and transient properties can be steadily evaluated without disconnection under environmental testing.

In this case, the micro LED can have a side of 50 µm or less.

With this configuration, the current-carrying properties of an extremely small micro LED-size device can be evaluated in an epitaxial wafer state as it is, and transient properties can be steadily evaluated without disconnection under environmental testing.

In this case, the micro LED can comprise a light-emitting layer and a GaP layer on the light-emitting layer,
the light-emitting layer can comprise a cladding layer, an active layer on the cladding layer, and another cladding layer on the active layer, and
the active layer can comprise (Al_{y}Ga_{1-y})ₓIn₁₋ₓP (0.4 ≤ x ≤ 0.6, 0 ≤ y ≤ 0.5).

With this configuration, the current-carrying properties of an extremely small, AlGaInP4-based micro LED-size device can be evaluated more reliably in an epitaxial wafer state as it is, and transient properties can be steadily evaluated without disconnection under environmental testing.

In this case, the pad base can comprise a light-emitting layer and a GaP layer on the light-emitting layer, and the GaP layer can have a thickness of 5 µm or more.

With this configuration, even when the GaP layer has a large thickness, the current-carrying properties of an extremely small micro LED-size device can be evaluated reliably in an epitaxial wafer state as it is, and transient properties can be steadily evaluated without disconnection under environmental testing.

In this case, the insulator can comprise any of SiO₂, SiNₓ, SOG, CYTOP (registered trademark), and polyimide.

With this configuration, while maintaining the insulation properties of the insulator, the current-carrying properties of an extremely small micro LED-size device can be evaluated more reliably in an epitaxial wafer state as it is, and transient properties can be steadily evaluated without disconnection under environmental testing.

In order to achieve the above object, the present invention provides a micro LED characteristic evaluation method comprising evaluating characteristics of a micro LED by using the wafer for micro LED characteristic evaluation as previously described.

With such a micro LED characteristic evaluation method, the current-carrying properties of a micro LED-size device can be evaluated in an epitaxial wafer state as it is, and transient properties can be steadily evaluated without disconnection under environmental testing.

### ADVANTAGEOUS EFFECTS OF INVENTION

As described above, with the inventive wafer for micro LED characteristic evaluation, the current-carrying properties of the micro LED-size device can be evaluated in the epitaxial wafer state as it is, and transient properties can be steadily evaluated without disconnection under environmental testing.

With the inventive micro LED characteristic evaluation method, the current-carrying properties of the micro LED-size device can be evaluated in the epitaxial wafer state as it is, and transient properties can be steadily evaluated without disconnection under environmental testing.

### BRIEF DESCRIPTION OF DRAWINGS

FIG. 1 is a cross-sectional view illustrating an example of a resist patterned substrate.
FIG. 2 is a cross-sectional view illustrating an example of a SiO₂ patterned substrate.
FIG. 3A is a cross-sectional view illustrating an example of a dry-etched substrate, taken along line A-A' in FIG. 3B.
FIG. 3B is a plan view of an example illustrating a dry-etched substrate.
FIG. 4 is a cross-sectional view illustrating an example of a wet-etched substrate.
FIG. 5 is a cross-sectional view illustrating an example of a coated substrate.
FIG. 6A is a cross-sectional view illustrating an example of an opened substrate, taken along line A-A' in FIG. 6B.
FIG. 6B is a plan view illustrating an example of the opened substrate.
FIG. 7A is a cross-sectional view illustrating an example of a wafer for micro LED characteristic evaluation according to the present invention, taken along line A-A' in FIG. 7B.
FIG. 7B is a plan view illustrating an example of the wafer for micro LED characteristic evaluation according to the present invention.
FIG. 8 is a cross-sectional view illustrating Comparative Example.
FIG. 9 is an experimental result showing a disconnected device occurrence rate (defective rate) in a case where dies are placed in an 85°C environment in Example and Comparative Example.
FIG. 10 is an experimental result illustrating a disconnected device occurrence rate (defective rate) in a case where dies are placed in a -40°C environment in Example and Comparative Example.

### DESCRIPTION OF EMBODIMENTS

Hereinafter, the present invention will be described in detail. However, the present invention is not limited thereto.

As described above, there is a need for a wafer for micro LED characteristic evaluation and a micro LED characteristic evaluation method that enable evaluation of current-carrying properties by forming a micro LED-size device in an epitaxial wafer state as it is, without processing an epitaxial wafer having AlGaInP-based micro LEDs optimum for the LLO process into a wafer structure for LLO, and enable steady evaluation of transient properties with a device structure free from disconnection under environmental testing.

The present inventors have conducted earnest studies on the above problem and found that, by using a wafer for micro LED characteristic evaluation that includes a GaAs substrate, a micro LED having a side of 100 µm or less on the GaAs substrate, a pad base adjacent to the micro LED, an upper electrode pad on the micro LED and the pad base, and a lower electrode pad on the GaAs substrate in the vicinity of the micro LED, in which the micro LED and the pad base are coupled through an insulator; the current-carrying properties of a micro LED-size device can be evaluated in an epitaxial wafer state as it is, and transient properties can be steadily evaluated without disconnection under environmental testing. This finding has led to the completion of the present invention.

Hereinafter, the inventive wafer for micro LED characteristic evaluation and the inventive micro LED characteristic evaluation method will be described.

### (Wafer for Micro LED Characteristic Evaluation)

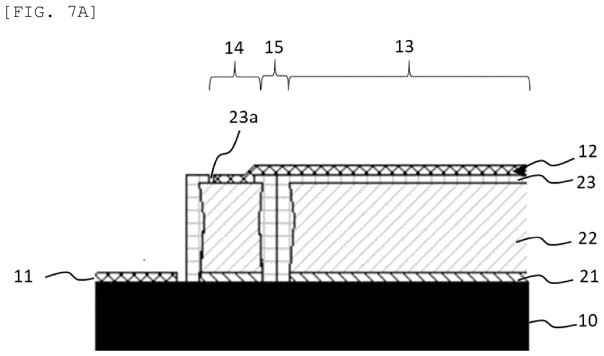

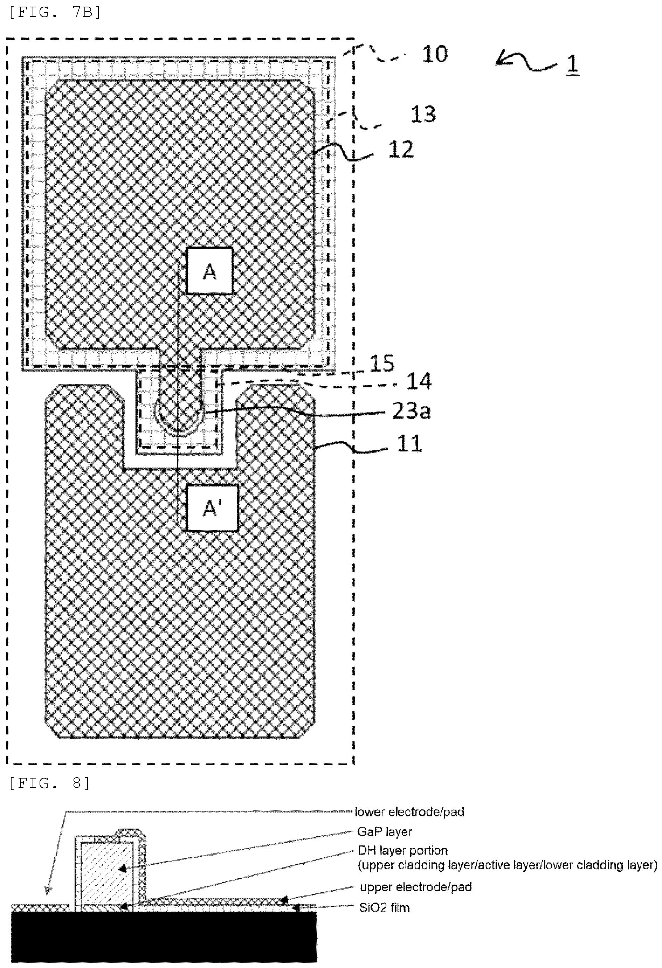

As shown in FIGs. 7A and 7B, a wafer 1 for micro LED characteristic evaluation according to the present invention includes a GaAs substrate 10, a micro LED 14 having a side of 100 µm or less on the GaAs substrate 10, a pad base 13 adjacent to the micro LED 14, an upper electrode pad 12 on the micro LED 14 and the pad base 13, and a lower electrode pad 11 on the GaAs substrate 10 in the vicinity of the micro LED 14, in which the micro LED 14 and the pad base 13 are coupled through an insulator 15.

An epitaxial wafer (EPW) having a light-emitting device structure as an epitaxial function layer is provided, in which a first conductivity-type GaAs buffer layer is stacked on a first conductivity-type GaAs substrate (starting substrate) 10, and then, for example, a first conductivity-type GaₓIn₁₋ₓP (0.4 ≤ x ≤ 0.6) first etching stop layer of 0.1 µm in thickness, for example, a first conductivity-type GaAs second etching stop layer of 0.1 µm in thickness, for example, a first conductivity-type (Al_{y}Ga_{1-y})ₓIn₁₋ₓP (0.4 ≤ x ≤ 0.6, 0.6 ≤ y ≤ 1.0) first cladding layer of 1.0 µm in thickness, a non-doped (Al_{y}Ga_{1-y})ₓIn₁₋ₓP (0.4 ≤ x ≤ 0.6, 0 ≤ y ≤ 0.5) active layer, for example, a second conductivity-type (Al_{y}Ga_{1-y})ₓIn₁₋ₓP (0.4 ≤ x ≤ 0.6, 0.6 ≤ y ≤ 1.0) second cladding layer of 1.0 µm in thickness, for example, a second conductivity-type GaₓIn₁₋ₓP (0.5 ≤ x ≤ 1.0) intermediate layer of 0.1 µm in thickness, and, for example, a second conductivity-type GaP layer (window layer) 22 of 6.0 µm in thickness are sequentially grown.

Here, the first cladding to the second cladding is referred to as a double hetero (DH) structure.

The double hetero (DH) structure is a light-emitting layer 21.

The thicknesses described above are just an example, and the thicknesses are merely parameters to be changed depending on the device operating specifications and are not limited to the thicknesses described here. Although a case where both the first and second cladding layers have a thickness of 1.0 µm is exemplified, a micro LED has a smaller rated current density than a discrete LED having a larger size, and the function as a cladding layer is not impaired even if the thickness is smaller than this thickness.

Since the electrode is formed in contact with the first cladding layer as described below, the first cladding layer suitably has a thickness of 0.6 µm or more, considering metal diffusion during ohmic contact formation. Any thickness can be selected as long as it is greater than this. However, when the thickness becomes too great, it is more likely to lead to a factor for increasing costs, reduced light emitting efficiency during constant-current drive, or decreased yields due to increased warpage of the wafer. Therefore, the thickness is preferably 10 µm or less.

When the second conductivity type is p-type, the effective mass of holes is large, so the second cladding having a thickness of, for example, about 0.2 µm functions in the same manner as that of 1.0 µm. Therefore, any thickness can be selected as long as it is 0.2 µm or more. However, when the thickness becomes too great, it is more likely to lead to a factor for increasing costs, reduced light emitting efficiency during constant-current drive, or decreased yields due to increased warpage of the wafer. Therefore, the thickness is preferably 10 µm or less.

Each layer conceptually includes a plurality of composition layers within the illustrated range of composition rather than a single composition layer. The carrier concentration level conceptually includes having a plurality of levels in each layer rather than being uniform in each layer.

The active layer may be composed of a single composition or may have a superlattice structure in which barrier layers and active layers are alternately stacked. Both structures have similar functions, and either can be selected. No matter which of the structures is selected, the operation effect of the present technique is the same.

The thickness of the GaP layer 22 is preferably 5 µm or more and can be 6 µm, for example. However, the thickness is not limited to 6 µm, and any thickness can be selected as long as it is smaller than the length of a shorter side of device isolation described later. The size of the micro LED 14 is 100 µm or less, and the lower limit can be, for example, but not limited to, 1 µm. The thickness of the GaP layer 22 does not exceed 100 µm.

The upper electrode pad 12 preferably has an area larger than the area of a circle with a diameter of 60 µm. The upper limit is not limited but can be 1000 µm, for example. This configuration ensures reliable wire bonding.

It is preferable that the upper electrode pad 12 includes a metal and the metal is any of Al, Cu, Ag, and Au. This configuration ensures reliable evaluation of current-carrying properties.

It is preferable that the upper electrode pad 12 includes a transparent conductive film and the transparent conductive film is any of ITO, InOₓ, NiO, and CuO. This configuration ensures reliable evaluation of current-carrying properties.

It is preferable that the micro LED 14 has a side of 50 µm or less. This configuration ensures evaluation of current-carrying properties of an extremely small device.

It is preferable that the micro LED 14 includes the light-emitting layer 21 and the GaP layer 22 on the light-emitting layer 21; the light-emitting layer 21 includes a cladding layer, an active layer on the cladding layer and another cladding layer on the active layer; and the active layer includes (Al_{y}Ga_{1-y})ₓIn₁₋ₓP (0.4 ≤ x ≤ 0.6, 0 ≤ y ≤ 0.5). This configuration ensures reliable evaluation of the current-carrying properties of an AlGaInP-based micro LED.

It is preferable that the pad base 13 includes the light-emitting layer 21 and the GaP layer 22 on the light-emitting layer 21, and the GaP layer 22 has a thickness of 5 µm or more. This configuration ensures reliable evaluation of current-carrying properties even when the GaP layer has a large thickness.

It is preferable that the insulator 15 includes any of SiO₂, SiNₓ, SOG, CYTOP (registered trademark), and polyimide. This configuration ensures reliable evaluation of current-carrying properties while maintaining the insulation properties of the insulator.

Next, the manufacturing step for a wafer for micro LED characteristic evaluation will be described.

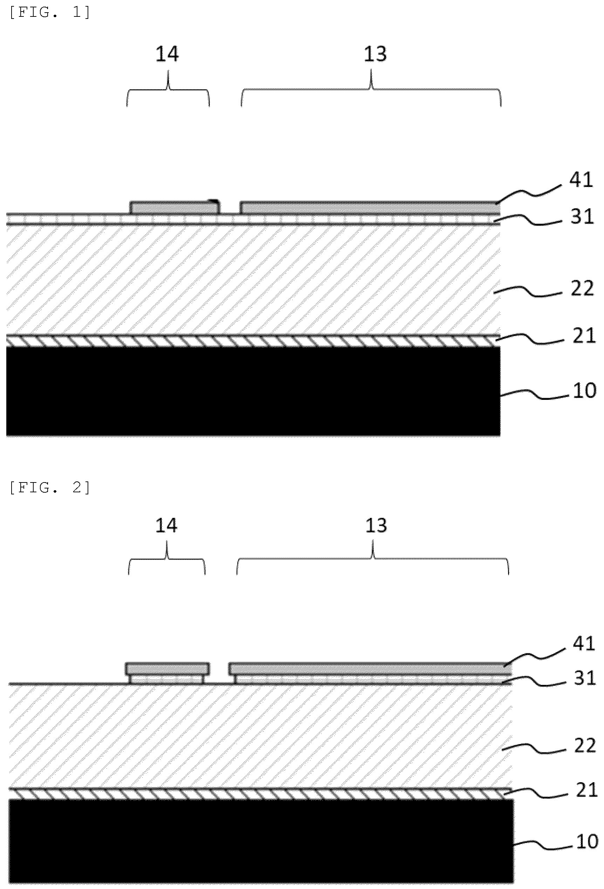

FIG. 1 is a cross-sectional view illustrating an example of a resist patterned substrate.

First, as shown in FIG. 1, a SiO₂ film 31 of 100 nm or more, for example, 400 nm, is formed on an epitaxial wafer. A resist pattern 41 is then formed such that an intended device formation portion for the micro LED 14 and an intended upper electrode pad formation portion for the pad base 13 are separately patterned.

The size and pattern of the intended device formation portion can be set freely, and the size can be 25 µm square, for example.

The intended upper electrode pad formation portion can be 95 µm square, for example.

The intended device formation portion and the intended upper electrode pad formation portion can be spaced apart from each other, for example, by 1 µm.

FIG. 2 is a cross-sectional view illustrating an example of a SiO₂ patterned substrate.

Next, as shown in FIG. 2, the SiO₂ film 31 is patterned by a wet etching process using a hydrofluoric acid solution, and the resist is removed to obtain a hard mask pattern of the SiO₂ film 31.

The wet etching process has a condition that is not fixed but can be changed as desired depending on the thickness of the hard mask of the SiO₂ film 31. For example, the pattern can be formed by immersion in approximately 50% BHF solution for 1 minute.

Any resist stripper can be selected as long as stripping can be achieved. For example, stripping can be performed using acetone.

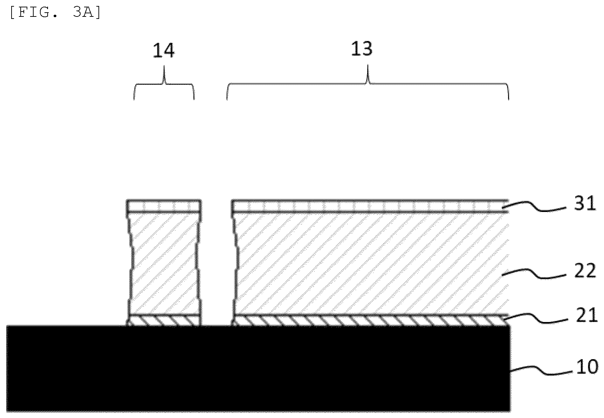

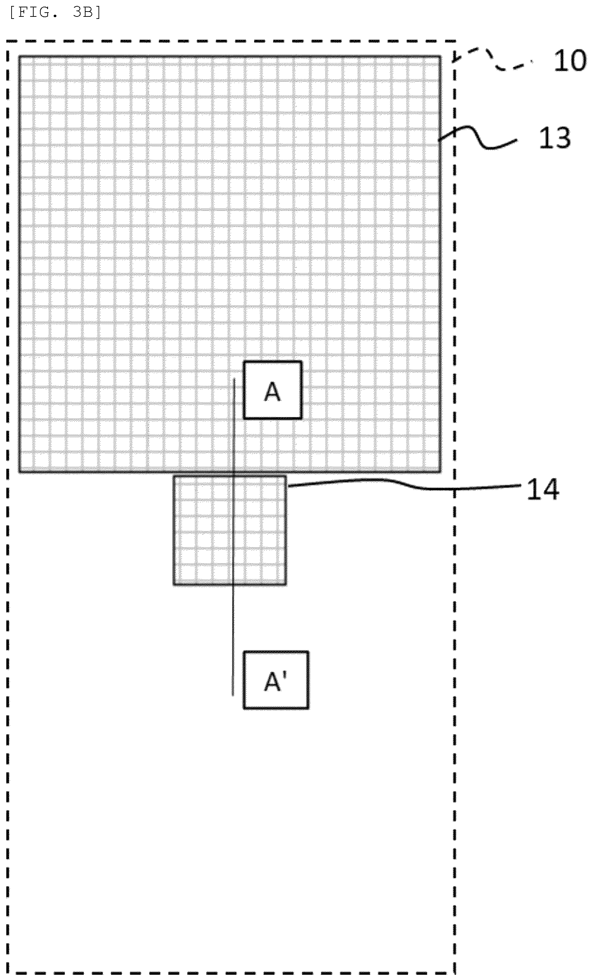

FIG. 3A is a cross-sectional view illustrating an example of a dry-etched substrate, taken along line A-A' in FIG. 3B. FIG. 3B is a plan view illustrating an example of a dry-etched substrate.

Next, as shown in FIGs. 3A and 3B, an ICP dry etching process is performed using a chlorine-containing gas to obtain a pattern including the intended device formation portion for the micro LED 14 and the intended upper electrode pad formation portion for the pad base 13.

ICP dry etching conditions can include, for example, an antenna power of 200 W and a bias power of 100 W, but are not limited to these conditions.

In ICP dry etching, for example, Cl₂ and Ar can be used as the chlorine-containing gas, but the chlorine-containing gas is not limited to this gas mixture. BCl₃, SiCl₄, HCl, or the like may be used as a chlorine source gas, and N₂ or He may be used instead of Ar.

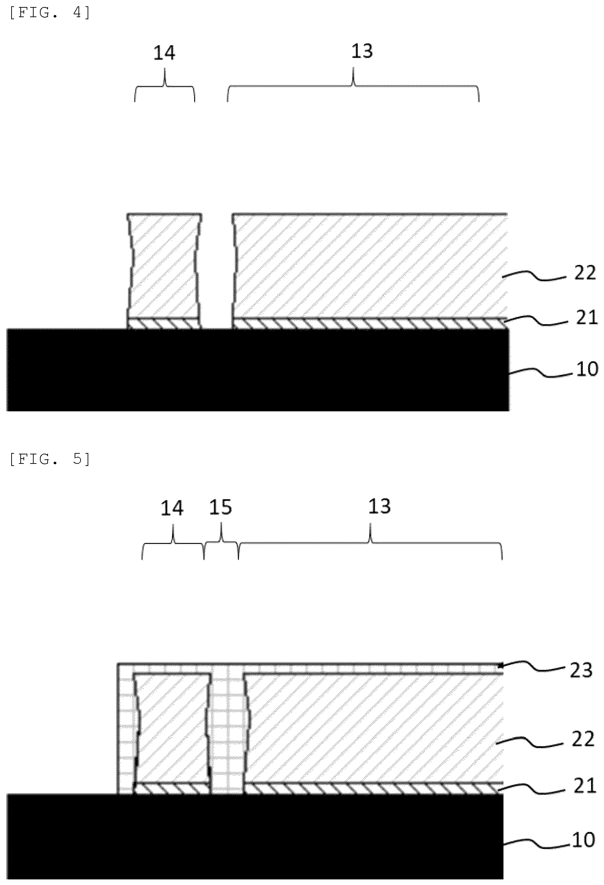

FIG. 4 is a cross-sectional view illustrating an example of a wet-etched substrate.

Next, as shown in FIG. 4, the hard mask of the SiO₂ film 31 is removed by a wet etching process using a hydrofluoric acid solution.

The wet etching process is a condition that is not fixed but can be changed as desired depending on the thickness of the hard mask of the SiO₂ film 31. For example, the hard mask can be removed by immersion for 1 minute using approximately 50% BHF solution.

FIG. 5 is a cross-sectional view illustrating an example of a coated substrate.

Next, as shown in FIG. 5, the front surface and end surfaces, including a gap between the intended device formation portion for the micro LED 14 and the intended upper electrode pad formation portion for the pad base 13, are coated with, for example, a TEOS-based SiO₂.

A coating film 23 is not limited to SiO₂ and any material can be selected as long as it can protect the end surfaces, has insulation properties, and has a higher thermal conductivity than GaAs of the starting substrate. The TEOS-based coating film has a high surface coverage, and a Si-containing insulating film such as SiNₓ can also be selected.

The coating film 23, other than a TEOS-based CVD film, may be formed by spinning or dipping. In this case, SiNₓ, SOG, CYTOP (registered trademark), polyimide, or the like can be selected.

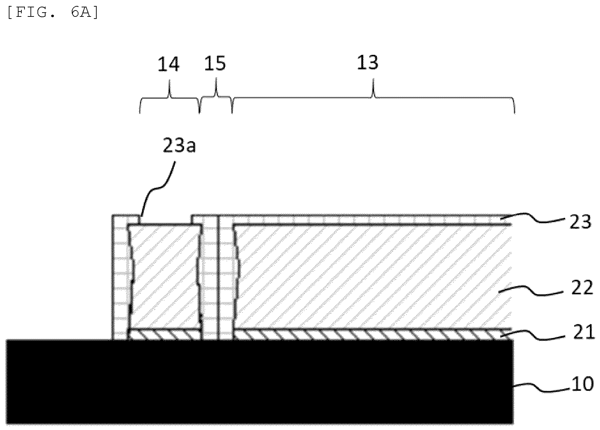

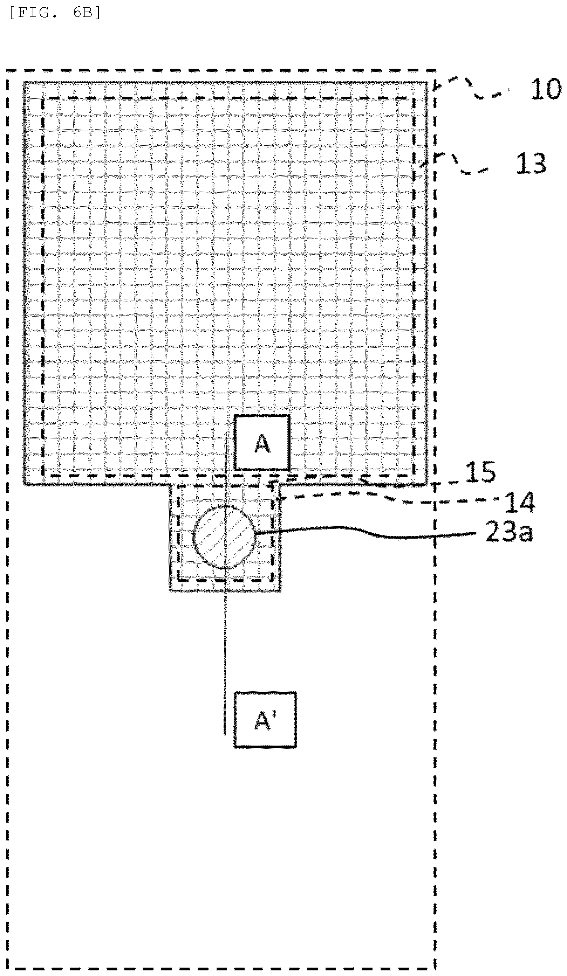

FIG. 6A is a cross-sectional view illustrating an example of an opened substrate, taken along line A-A' in FIG. 6B. FIG. 6B is a plan view illustrating an example of the opened substrate.

Next, as shown in FIG. 6, an opening 23a is formed in the coating film 23 as an upper electrode contact target section by a photolithography method and a wet etching method.

FIG. 7A is a cross-sectional view of a wafer for micro LED characteristic evaluation according to the present invention, taken along line A-A' in FIG. 7B. FIG. 7B is a plan view illustrating an example of the wafer for micro LED characteristic evaluation according to the present invention.

Next, as shown in FIGs. 7A and 7B, a lower electrode pad 11 and an upper electrode pad 12 are formed and subjected to heat treatment to form an ohmic contact.

Although a case is exemplified in which the intended device formation portion for the micro LED 14 and the intended upper electrode pad formation portion for the pad base 13 are connected by a metal in the upper electrode pad 12, the connecting portion is not limited to a metal only. The pad electrode portion and the contact electrode of the micro LED 14 may be metal and electrically connected by a transparent conductive film. ITO, InOₓ, NiO, CuOₓ, or the like can be used as the transparent conductive film.

The first conductivity type can be designed as n type and the second conductivity type as p type, and a metal containing Au and Si can be used for an electrode in contact with an n-type layer, and a metal containing Au and Be can be used for an electrode in contact with a p-type layer.

In addition, the n-type electrode is not limited to a metal containing Au and Si, but a metal containing Au and Ge may be used. Moreover, the p-type electrode is not limited to Au and Be, but a metal containing Au and Zn may be used.

After the electrodes are formed, an ohmic contact is realized by performing an RTA treatment at 400°C for 5 minutes. After realizing the ohmic contact, wire bonding is performed to provide a form that enables environmental testing and transient properties testing. The above structure makes it possible to test the dependence and transient properties of an epitaxial wafer on the environment.

### (Micro LED Characteristic Evaluation Method)

The micro LED characteristic evaluation method according to the present invention is a method for evaluating the characteristics of the micro LED 14 using the wafer 1 for micro LED characteristic evaluation described above. This method enables evaluation of the current-carrying properties of the micro LED 14 in an epitaxial wafer state as it is, and enables steady evaluation of transient properties without disconnection under environmental testing.

### EXAMPLE

Hereinafter, the present invention will be specifically described with reference to Example. However, the present invention is not limited thereto.

### (Example)

An epitaxial wafer having a light-emitting structure as an epitaxial function layer was prepared, in which an n-type GaAs buffer layer was stacked on an n-type GaAs starting substrate, and then an n-type GaₓIn₁₋ₓP (0.4 ≤ x ≤ 0.6) first etching stop layer of 0.1 µm in thickness, an n-type GaAs second etching stop layer of 0.1 µm in thickness, an n-type (Al_{y}Ga_{1-y})ₓIn₁₋ₓP (0.4 ≤ x ≤ 0.6, 0.6 ≤ y ≤ 1.0) first cladding layer of 1.0 µm in thickness, a non-doped (Al_{y}Ga_{1-y})ₓIn₁₋ₓP (0.4 ≤ x ≤ 0.6, 0 ≤ y ≤ 0.5) active layer, a p-type (Al_{y}Ga_{1-y})ₓIn₁₋ₓP (0.4 ≤ x ≤ 0.6, 0.6 ≤ y ≤ 1.0) second cladding layer of 1.0 µm in thickness, a p-type GaₓIn₁₋ₓP (0.5 ≤ x ≤ 1.0) intermediate layer of 0.1 µm in thickness, and a p-type GaP window layer of 6 µm in thickness were sequentially grown.

A SiO₂ film of 400 nm was formed on the epitaxial wafer, and a resist pattern was formed such that an intended micro LED device formation portion and an intended upper electrode pad formation portion were separately patterned (FIG. 1). The intended device formation portion had a size of 25 µm square. The intended upper electrode pad formation portion had a size of 95 µm square. The intended device isolation formation portion and the intended upper electrode pad formation portion were arranged with space apart from each other by 1 µm.

The SiO₂ film was patterned by immersion in approximately 50% BHF solution for 1 minute (FIG. 2), and the resist was removed with acetone to obtain a SiO₂ hard mask pattern.

Next, an ICP dry etching process was performed using Cl₂ and Ar to obtain a pattern of a device isolation portion and a pad portion (FIGs. 3A and 3B). ICP dry etching was performed under conditions including an antenna power of 200 W and a bias power of 100 W.

The SiO₂ hard mask was then removed by immersion in approximately 50% BHF solution for 1 minute (FIG. 4).

Next, the front surface and end surfaces, including a gap between the device portion and the pad portion, were coated with TEOS-based SiO₂ (FIG. 5).

Next, the upper electrode contact target section was opened by a photolithography method and a wet etching method (FIGs. 6A and 6B), and a lower electrode and an upper electrode were formed and subjected to heat treatment to form an ohmic contact (FIGs. 7A and 7B).

Here, a metal containing Au and Si was used for the electrode in contact with the n-type layer, and a metal containing Au and Be was used for the electrode in contact with the p-type layer.

After the electrodes were formed, an ohmic contact was realized by performing an RTA treatment at 400°C for 5 minutes. After the ohmic contact was formed, wire bonding was performed.

### (Comparative Example)

FIG. 8 is a cross-sectional view showing Comparative Example.

The steps of forming and processing an epitaxial wafer were similar to that of Example. However, as shown in FIG. 8, an intended pad formation portion was entirely etched off to leave only a device portion, and an insulating film was formed on the side surface of the device section, and wiring was formed on the insulating film.

### (Comparison Between Example and Comparative Example)

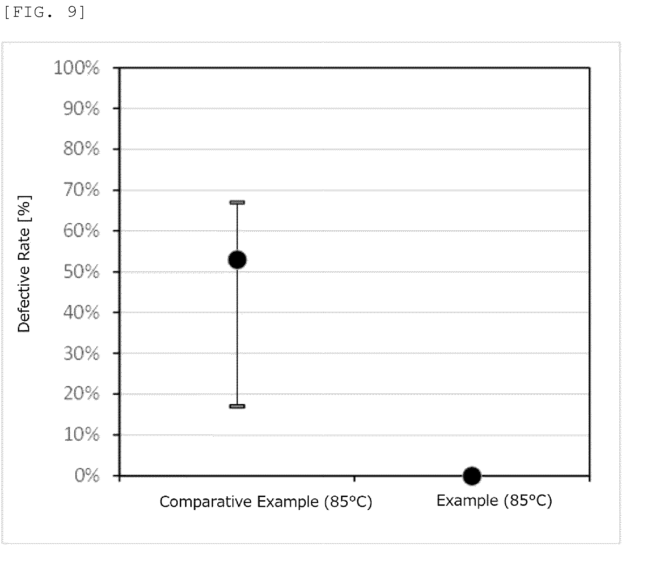

FIG. 9 shows an experimental result indicating a disconnected device occurrence rate (defective rate) in a case where dies are placed in an 85°C environment in Example and Comparative Example.

In Comparative Example, when the dies are installed in an environment of 85°C, which is the standard environment for life tests, and checked for current-carrying capability, a short circuit (disconnection) occurs in 20% to half or more of the dies. This disconnection is temporary, and when the dies are returned to room temperature, the short circuit is eliminated, and the dies are restored to a current-carrying state.

In Comparative Example, as shown in FIG. 8, since the upper electrode pad is on the GaAs substrate, disconnection and reconnection occur due to the thermal expansion coefficients of the metal forming the wiring, the insulating material, and the material forming the light-emitting portion, as well as the unevenness of the metal wiring portion caused by the device cross-sectional shape, and the unevenness of the insulating material. To solve this, it is necessary to form a quite thick (10 µm or more) metal layer, but it is not easy to form a thick metal layer in a photo process. This choice is not preferable because the process time is increased, and excessive material use is required.

On the other hand, when Example was applied, no disconnection occurred even in an 85°C environment, and the defective rate was significantly reduced compared with Comparative Example, because the upper electrode pad is on the pad base including a DH layer, and the metal wiring portion is short and almost straight.

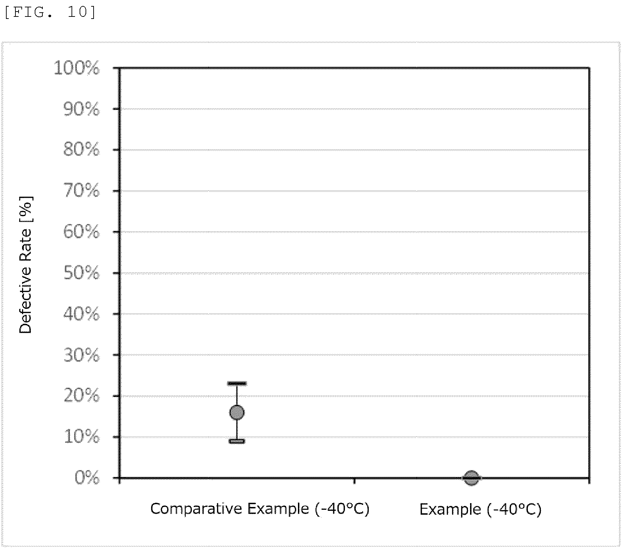

FIG. 10 shows an experimental result indicating a disconnected device occurrence rate (defective rate) in a case where dies are placed in a -40°C environment in Example and Comparative Example.

In Comparative Example, when the dies are installed in a -40°C environment, which is the standard environment for life tests, and checked for current-carrying capability, a short circuit (disconnection) occurs in 10 to 20% of the dies. This disconnection is temporary, and when the die is returned to room temperature, the short circuit is eliminated and the die is restored to a current-carrying state.

Disconnection and reconnection occur due to the thermal expansion coefficients of the metal forming the wiring, the insulating material, and the material forming the light-emitting portion, as well as the unevenness of the metal wiring portion caused by the device cross-sectional shape, and the unevenness of the insulating material. To solve this, it is necessary to form a quite thick (10 µm or more) metal layer, but it is not easy to form a thick metal layer in a photo process. This choice is not preferable because the process time is increased and excessive material use is required.

On the other hand, when Example was applied, no disconnection occurred even in a -40°C environment, and the defective rate was significantly reduced compared with Comparative Example.

As described above, according to Example of the present invention, the current-carrying properties of a micro LED-size device can be evaluated in an epitaxial wafer state as it is, and transient properties can be evaluated without disconnection under environmental testing.

The present description includes the following embodiments.
[1]: A wafer for micro LED characteristic evaluation, the wafer comprising:
   a GaAs substrate;
   a micro LED having a side of 100 µm or less on the GaAs substrate;
   a pad base adjacent to the micro LED; an upper electrode pad on the micro LED and the pad base; and
   a lower electrode pad on the GaAs substrate in a vicinity of the micro LED,
   wherein the micro LED and the pad base are coupled through an insulator.
[2]: The wafer for micro LED characteristic evaluation according to the above [1], wherein the upper electrode pad has an area larger than an area of a circle with a diameter of 60 µm.
[3]: The wafer for micro LED characteristic evaluation according to the above [1] or [2], wherein the upper electrode pad comprises a metal, and the metal is any of Al, Cu, Ag, and Au.
[4]: The wafer for micro LED characteristic evaluation according to any of the above [1] to [3], wherein the upper electrode pad comprises a transparent conductive film, and the transparent conductive film is any of ITO, InOₓ, NiO, and CuO.
[5]: The wafer for micro LED characteristic evaluation according to any of the above [1] to [4], wherein the micro LED has a side of 50 µm or less.
[6]: The wafer for micro LED characteristic evaluation according to any of the above [1] to [5], wherein
   the micro LED comprises a light-emitting layer and a GaP layer on the light-emitting layer,
   the light-emitting layer comprises a cladding layer, an active layer on the cladding layer, and another cladding layer on the active layer, and
   the active layer comprises (Al_{y}Ga_{1-y})ₓIn₁₋ₓP (0.4 ≤ x ≤ 0.6, 0 ≤ y ≤ 0.5).
[7]: The wafer for micro LED characteristic evaluation according to amy of the above [1] to [6], wherein
   the pad base comprises a light-emitting layer and a GaP layer on the light-emitting layer, and
   the GaP layer has a thickness of 5 µm or more.
[8]: The wafer for micro LED characteristic evaluation according to any of the above [1] to [7], wherein the insulator comprises any of SiO₂, SiNₓ, SOG, CYTOP (registered trademark), and polyimide.
[9]: A micro LED characteristic evaluation method comprising evaluating characteristics of a micro LED by using the wafer for micro LED characteristic evaluation according to any of the above [1] to [8].

It should be noted that the present invention is not limited to the above-described embodiments. The embodiments are just examples, and any examples that substantially have the same feature and demonstrate the same functions and effects as those in the technical concept disclosed in claims of the present invention are included in the technical scope of the present invention.

## Claims

1. A wafer for micro LED characteristic evaluation, the wafer comprising:
a GaAs substrate;
a micro LED having a side of 100 µm or less on the GaAs substrate;
a pad base adjacent to the micro LED;
an upper electrode pad on the micro LED and the pad base; and
a lower electrode pad on the GaAs substrate in a vicinity of the micro LED,
wherein the micro LED and the pad base are coupled through an insulator.

2. The wafer for micro LED characteristic evaluation according to claim 1, wherein the upper electrode pad has an area larger than an area of a circle with a diameter of 60 µm.

3. The wafer for micro LED characteristic evaluation according to claim 1 or 2, wherein the upper electrode pad comprises a metal, and the metal is any of Al, Cu, Ag, and Au.

4. The wafer for micro LED characteristic evaluation according to claim 1 or 2, wherein the upper electrode pad comprises a transparent conductive film, and the transparent conductive film is any of ITO, InOₓ, NiO, and CuO.

5. The wafer for micro LED characteristic evaluation according to claim 1 or 2, wherein the micro LED has a side of 50 µm or less.

6. The wafer for micro LED characteristic evaluation according to claim 1 or 2, wherein
the micro LED comprises a light-emitting layer and a GaP layer on the light-emitting layer,
the light-emitting layer comprises a cladding layer, an active layer on the cladding layer, and another cladding layer on the active layer, and
the active layer comprises (Al_{y}Ga_{1-y})ₓIn₁₋ₓP (0.4 ≤ x
≤ 0.6, 0 ≤ y ≤ 0.5).

7. The wafer for micro LED characteristic evaluation according to claim 1 or 2, wherein
the pad base comprises a light-emitting layer and a GaP layer on the light-emitting layer, and
the GaP layer has a thickness of 5 µm or more.

8. The wafer for micro LED characteristic evaluation according to claim 1 or 2, wherein the insulator comprises any of SiO₂, SiNₓ, SOG, CYTOP (registered trademark), and polyimide.

9. A micro LED characteristic evaluation method comprising evaluating characteristics of a micro LED by using the wafer for micro LED characteristic evaluation according to claim 1 or 2.
